# EUROPEAN PATENT APPLICATION

(11) **EP 4 726 498 A1**
(43) Date of publication of application: **15.04.2026**
(21) Application number: 25206458.9
(22) Date of filing: 02.10.2025
(51) Int. Cl.: G06F 1/16, H04M 1/02, H04M 1/04

(54) **CASE FOR A PORTABLE ELECTRONIC DEVICE**

(30) Priority: 11.10.2024 US 202463706280 P
(71) Applicant: ACCO Brands Corporation, Lake Zurich, IL 60047 (US)
(72) Inventor: KLINKMAN, Alex J., Campbell, CA 95008 (US); TSE, Wilson S., Burnaby, BC V5J 2T4 (CA)
(74) Representative: Forresters IP LLP

(57) **Abstract**

A case for a portable electronic device having a kickstand, the case including: a plurality of sidewalls including a first sidewall having a lip configured to securely couple the kickstand to the case; a rear wall coupled to at least one sidewall of the plurality of sidewalls; and a cavity defined by the plurality of sidewalls and the rear wall, the cavity configured to receive the portable electronic device such that the plurality of sidewalls and the rear wall support the portable electronic device, wherein the lip of the first sidewall extends into the cavity.

## Description

### CROSS-REFERENCE TO RELATED APPLICATIONS

This application claims priority to U.S. Provisional Application No. 63/706,280, filed October 11, 2024, the entire contents of which are incorporated by reference herein.

### FIELD OF THE INVENTION

The present invention relates to a case, and more particularly a portable electronic device case.

### BACKGROUND OF THE INVENTION

Portable electronic devices such as tablets computers, cellular phones such as smart phones, and laptop computers can be placed within cases to protect the portable electronic device. Some cases may provide added functionality such as incorporating a screen protector for covering a screen of the portable electronic device, ports for coupling peripheral devices to the portable electronic device, or a kickstand for supporting the portable electronic device at an angle relative to a tabletop surface.

### SUMMARY OF THE INVENTION

In some aspects, the techniques described herein relate to a case for a portable electronic device having a kickstand, the case including: a plurality of sidewalls including a first sidewall having a lip configured to securely couple the kickstand to the case; a rear wall coupled to at least one sidewall of the plurality of sidewalls; and a cavity defined by the plurality of sidewalls and the rear wall, the cavity configured to receive the portable electronic device such that the plurality of sidewalls and the rear wall support the portable electronic device, wherein the lip of the first sidewall extends into the cavity.

In some aspects, the techniques described herein relate to a case for a portable electronic device having a kickstand, the case including: a plurality of sidewalls including at least one sidewall having a lip configured to securely couple the kickstand to the case, the lip having a recess defined therein; a cavity defined by the plurality of sidewalls, the cavity configured to receive the portable electronic device such that the plurality of sidewalls support the portable electronic device; and a magnetic member received within the recess, the magnetic member configured to interact with the kickstand and magnetically secure the kickstand with the case.

In some aspects, the techniques described herein relate to a case for a portable electronic device having a kickstand, the case including: a plurality of sidewalls; a lip extending from a first sidewall of the plurality of sidewalls and configured to securely couple the kickstand to the case; a set of ribs formed along an interior portion of a second sidewall of the plurality of sidewalls; a rear wall coupled to one of the plurality of sidewalls; and a cavity defined by the plurality of sidewalls and the rear wall, the cavity configured to receive the portable electronic device such that the plurality of sidewalls and the rear wall support the portable electronic device, wherein the lip of the first sidewall extends into the cavity.

### BRIEF DESCRIPTION OF DRAWINGS

FIG. 1A is a top perspective view of a case for a portable electronic device according to an embodiment of the present invention.
FIG. 1B is another top perspective view of the case of FIG. 1A.
FIG. 2 is a bottom perspective view of the case of FIG. 1A.
FIG. 3 is a side view of a right sidewall of the case of FIG. 1A.
FIG. 4 is a side view of a top sidewall of the case of FIG. 1A.
FIG. 5 is an exploded view of the case of FIG. 1A.
FIG. 6 is a perspective view of the portable electronic device and the case of FIG. 1A.
FIG. 7 is a top perspective view of the portable electronic device of FIG. 6 being inserted into the case of FIG. 1A.
FIG. 8 is a bottom perspective view of the portable electronic device of FIG. 6 being inserted into the case of FIG. 1A.
FIG. 9 is a perspective view of the portable electronic device of FIG. 6 coupled to the case of FIG. 1A, the portable electronic device having a kickstand in an extended position.
FIG. 10 is another perspective view of the portable electronic device of FIG. 6 coupled to the case of FIG. 1A with the kickstand in the extended position.
FIG. 11 is a cross-sectional view of the portable electronic device of FIG. 6 coupled to the case of FIG. 1A with the kickstand in the extended position.
FIG. 12 is a perspective view of the portable electronic device of FIG. 6 coupled to the case of FIG. 1A with the kickstand in a stowed position.
FIG. 13 is a cross-sectional view of the portable electronic device of FIG. 6 coupled to the case of FIG. 1A with the kickstand of FIG. 9 in the stowed position.

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways. Also, it is to be understood that the phraseology and terminology used herein is for the purpose of description and should not be regarded as limiting.

### DETAILED DESCRIPTION

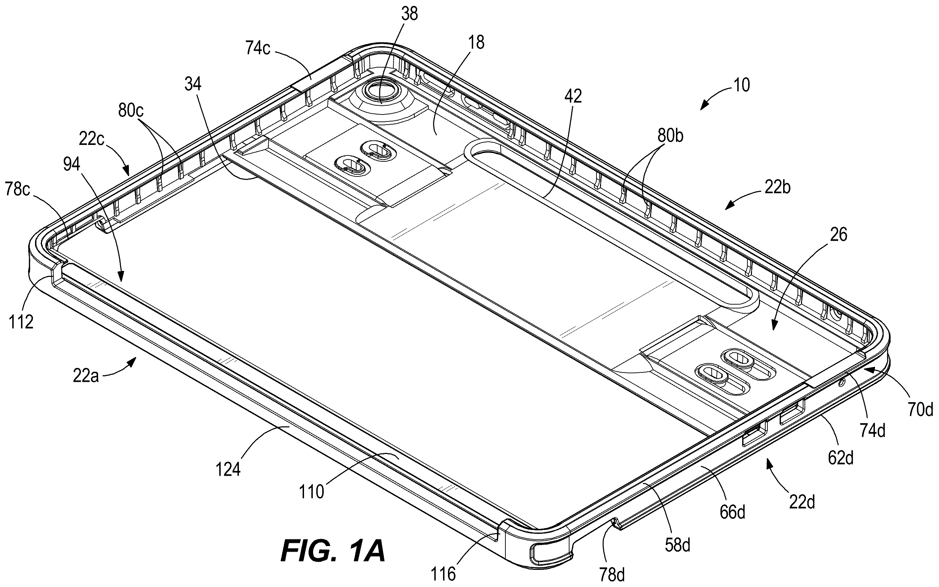

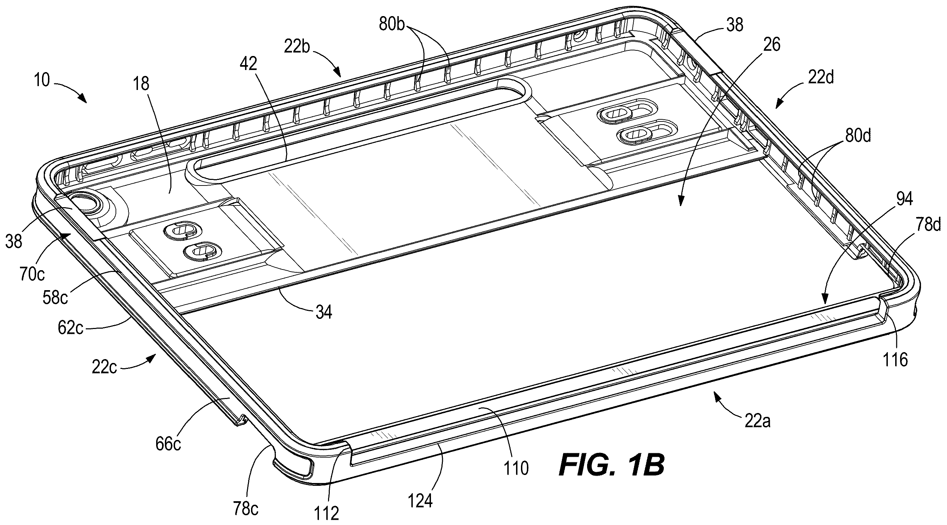

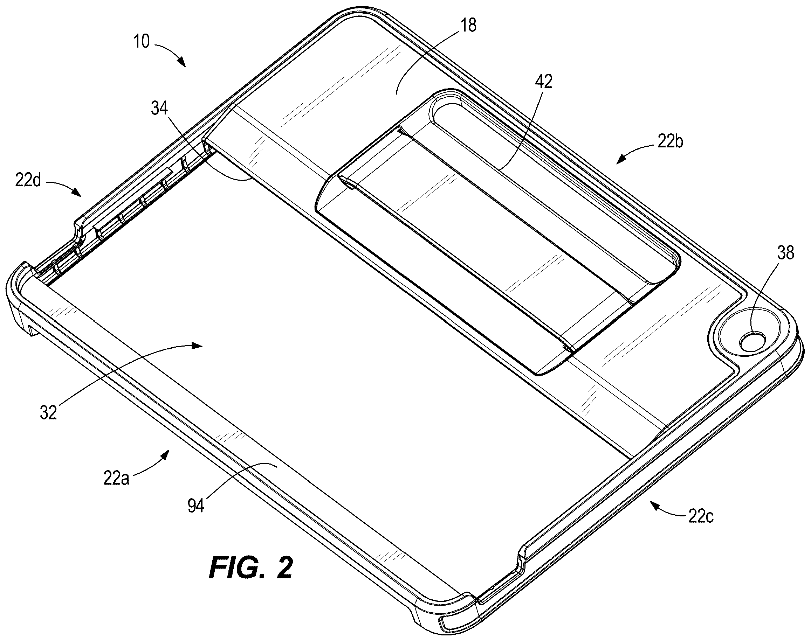

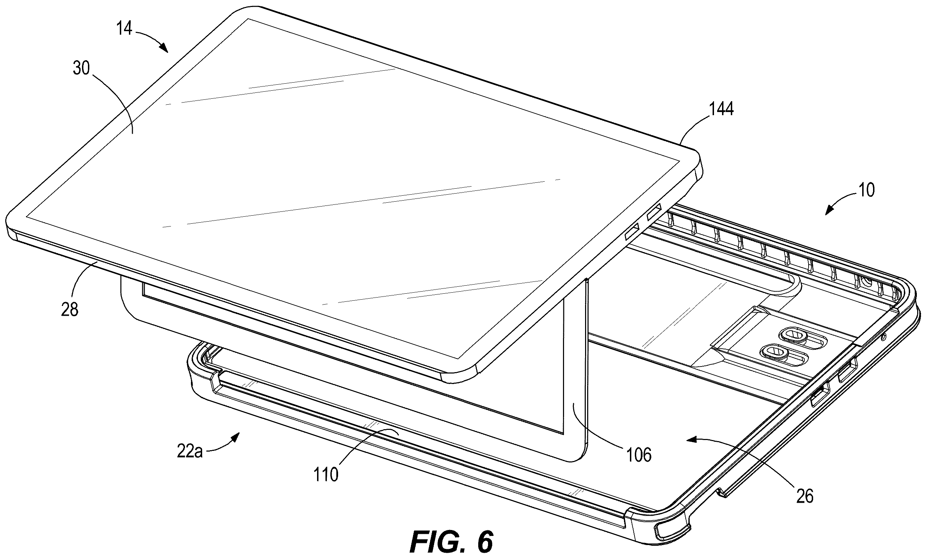

FIGS. 1A, 1B, and 2 illustrate a case 10 for a portable electronic device 14 (FIG. 6). The portable electronic device 14 may be, for example, a tablet or laptop computer. More particularly, the portable electronic device 14 may be a Surface Pro computer sold by Microsoft^{®}. In other embodiments, the case 10 may be usable with other types of portable electronic devices. The illustrated case 10 includes a rear wall 18 and four sidewalls 22a-22d that collectively define a cavity 26 configured to receive the device 14. The four sidewalls 22a-22d includes a first sidewall or bottom sidewall 22a, a second sidewall or top sidewall 22b, a third sidewall or left sidewall 22c, and a fourth sidewall or right sidewall 22d. The sidewalls 22a-22d are formed to extend around a periphery 28 (FIG. 6) of the device 14 and over a portion of a front surface 30 of the device 14 when the case 10 is coupled to the device 14.

The rear wall 18 is integrally formed with the top sidewall 22b, the left sidewall 22c, and the right sidewall 22d. The rear wall 18 is spaced from the bottom sidewall 22a such that a rear opening 32 (FIG. 2) is defined within the case 10. The rear opening 32 is defined between an edge 34 of the rear wall 18, a portion of the left sidewall 22c that is not connected to the rear wall 18, a portion of the right sidewall 22d that is not connected to the rear wall 18, and the bottom sidewall 22a. As such, the rear wall 18 is disposed at an upper portion of the case 10 and does not connect with any portion of the bottom sidewall 22a.

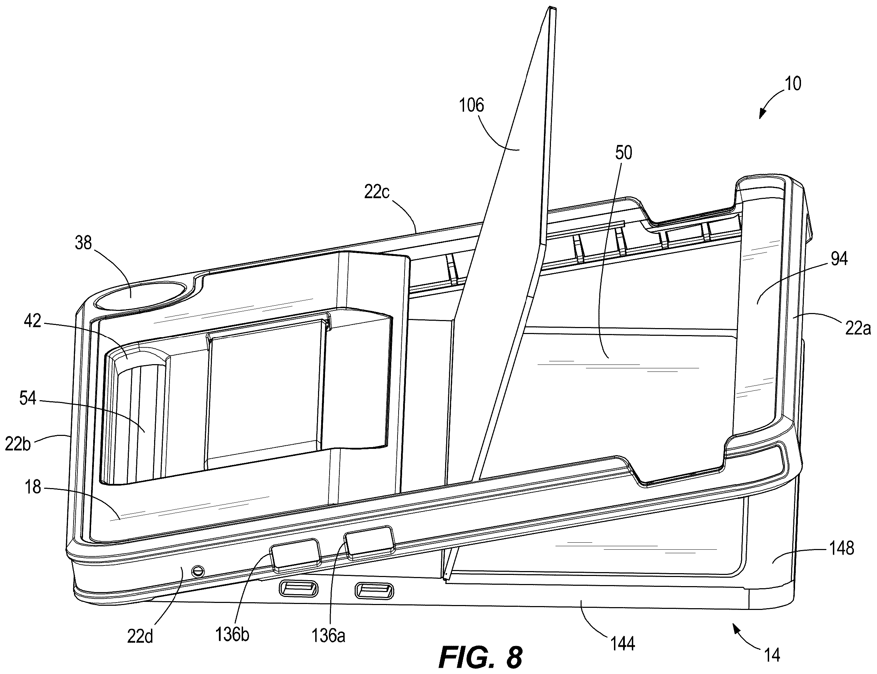

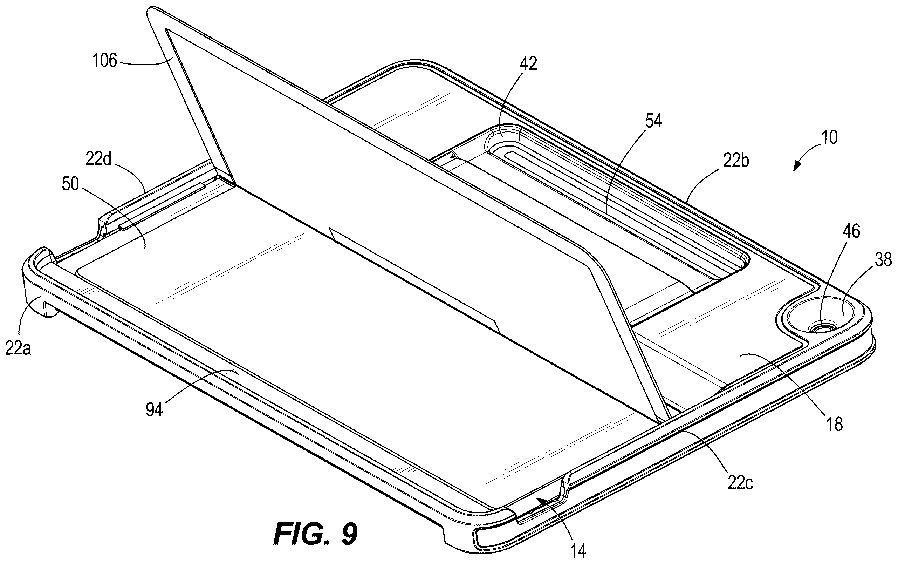

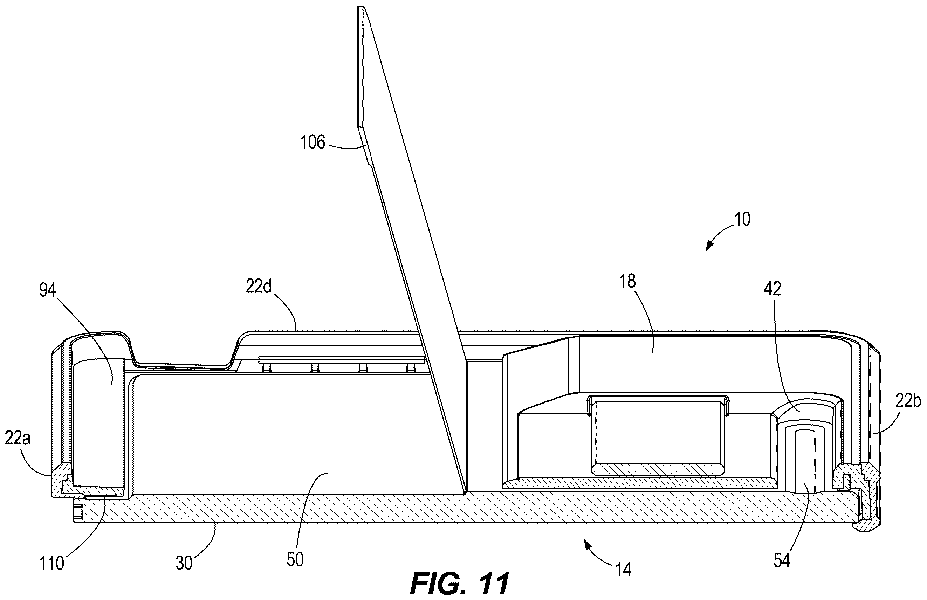

With continued reference to FIGS. 1A, 1B, and 2, the case 10 includes a camera opening 38 (e.g., a first opening) and a pen opening 42 (e.g., a second opening) that are defined within the rear wall 18. The camera opening 38 is located at an intersection portion between the top sidewall 22b and the left sidewall 22c. The camera opening 38 is arranged to surround and align with a camera 46 (FIG. 9) located on a rear surface 50 of the device 14 when the case 10 is coupled to the device 14. The pen opening 42 is located at a central portion of the case 10 and adjacent the top sidewall 22b. Also, the pen opening 42 has an elongated oblong shape. When the case 10 is coupled to the device 14, the pen opening 42 is arranged to align with an indent 54 (FIGS. 8-13) defined within the rear surface 50 of the device 14. The pen opening 42 and the indent 54 are configured to receive an electronic pen (or other writing implement, not shown) that is compatible with the device 14. In other embodiments, the camera opening 38 and the pen opening 42 may be located elsewhere on the case 10 and/or have different configurations, depending on the device 14. In some embodiments, the camera opening 38 and/or the pen opening 42 may be omitted.

The top sidewall 22b, the left sidewall 22c, and the right sidewall 22d of the case 10 are respectively formed with a top bevel edge 58b-d, a bottom bevel edge 62b-d, and a wall surface 66b-d extending therebetween. The top bevel edges 58b-d and the bottom bevel edges 62b-d extend outwardly. In the illustrated embodiment, the left sidewall 22c and the right sidewall 22d each include a height that is constant. In other embodiments, the left sidewall 22c and the right sidewall 22d may taper such that the left and right sidewalls 22c, 22d each include a height that varies. In addition, a recess 70b-d is defined within each wall surface 66b-d.

The left sidewall 22c and the right sidewall 22d each include a flat indentation 74c, 74d and a groove 78c, 78d. Each flat indentation 74c, 74d is formed on a corresponding top bevel edge 58c, 58d. The groove 78c of the left sidewall 22c extends from the bottom bevel edge 62c and terminates at a central portion of the wall surface 66c. The groove 78d of the right sidewall 22d extends from the bottom bevel edge 62d and terminates at a central portion of the wall surface 66d.

Multiple sets of ribs 80b-d are respectively formed along an interior portion of the top sidewall 22b, the left sidewall 22c, and the right sidewall 22d. The ribs 80b-d are spaced from each other and extend along a length of the sidewalls 22b-d. As such, each set of ribs 80b-d is arranged to abut the device 14 when inserted into the case 10. The ribs 80b-d help provide crush resistance between the case 10 and the device 14. In other embodiments, the interior portion of the top sidewall 22b, the left sidewall 22c, and the right sidewall 22d may have a smooth surface.

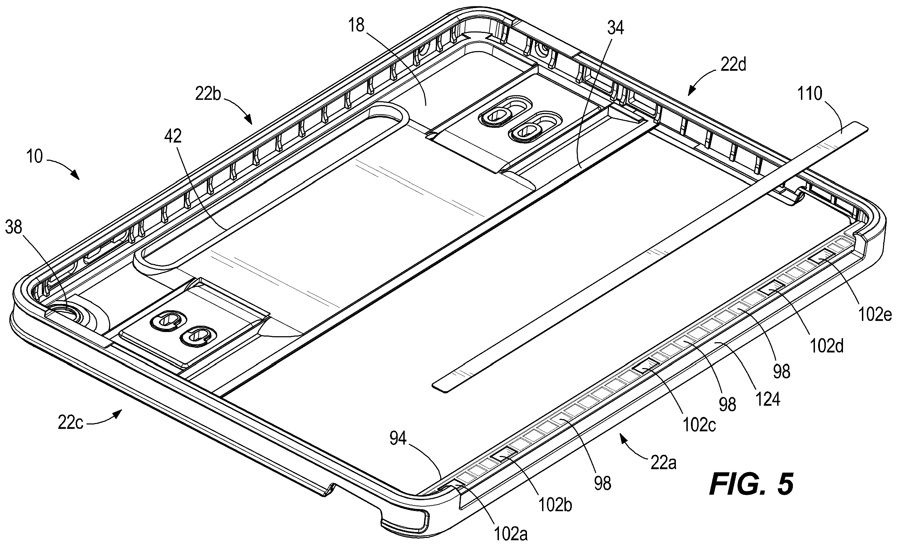

With reference to FIGS. 1A, 1B, 2, and 5, the bottom sidewall 22a includes a bridge or lip 94 extending between the left and right sidewalls 22c, 22d. The lip 94 is oriented to extend into the cavity 26 of the case 10. More specifically, the lip 94 is oriented to extend in a direction toward the rear wall 18. Also, the lip 94 has a plurality of recesses 98 defined therein and that extend along a length of the bottom sidewall 22a. In the illustrated embodiment, each recess 98 has a rectangular shape. In other embodiments, each recess 98 may have other shapes (e.g., a circular shape, a triangular shape, etc.). In still other embodiments, the lip 94 may have a single recess 98 that extends an entire length or part of the length of the bottom sidewall 22a. In the illustrated embodiment, the case 10 includes five magnetic members 102a-e that are received and secured within a respective recess 98. In other embodiments, the case 10 may include more or less than five magnetic members 102a-e. Additionally, in other embodiments, a single elongated magnetic member may be received in a single recess. Also, adjacent magnetic members 102a-e are spaced apart from each other such that the magnetic members 102a-e span across the length of the bottom sidewall 22a between the left and right sidewalls 22c, 22d. In the illustrated embodiment, the magnetic members 102a-e are not evenly spaced along the length of the bottom sidewall 22a, but in other embodiments they may be evenly spaced along the length. The magnetic members 102a-e are provided within the lip 94 to magnetically secure a kickstand 106 (FIG. 6) of the device 14 against the lip 94 when the device 14 is inserted into the case 10.

The bottom sidewall 22a further includes a cover 110. The illustrated cover 110 is formed as a flat plate. The cover 110 is coupled to the lip 94 and lies over the plurality of recesses 98 and the magnetic members 102a-e. As such, the cover 110 is arranged to face the rear surface 50 of the device 14 when the device 14 is inserted into the case 10. In some embodiments, the cover 110 may be securely coupled to the lip 94 by an adhesive. In other embodiments, the cover 110 may be securely coupled to the lip 94 by any suitable fastening mechanism.

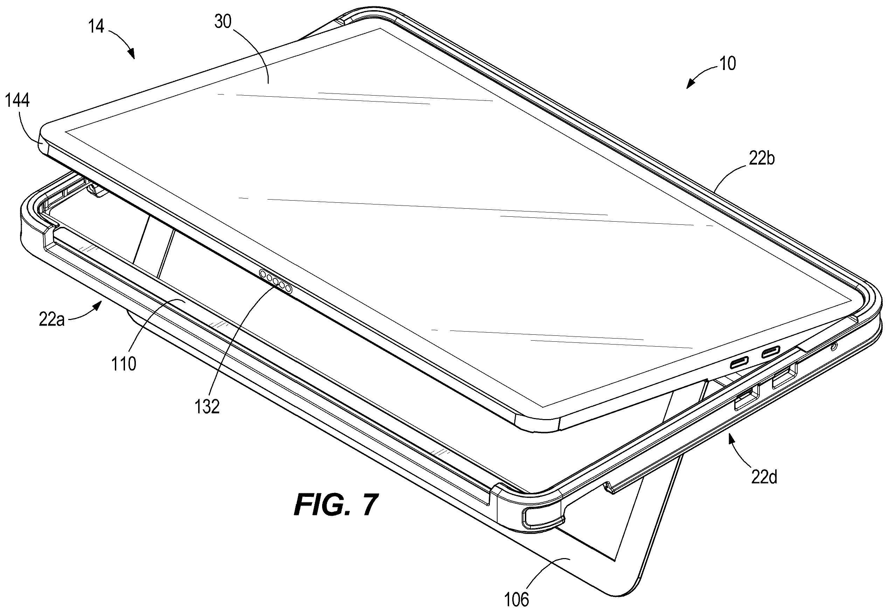

Moreover, the bottom sidewall 22a includes a first end 112, a second end 116, and a bottom edge 124 extending between the first and second ends 112, 116. The first end 112 is spaced a distance from the second end 116 such that a gap defined is therebetween. The bottom edge 124 is arranged along the bottom sidewall 22a such that the lip 94 extends from the bottom edge 124. When the device 14 is inserted into the case 10, the gap permits access to the periphery 28 of the device 14 for removal of the device 14 from the case 10. Also, the gap allows a speaker 132 (FIG. 7) provided on the device 14 to be exposed and not covered by the bottom sidewall 22a.

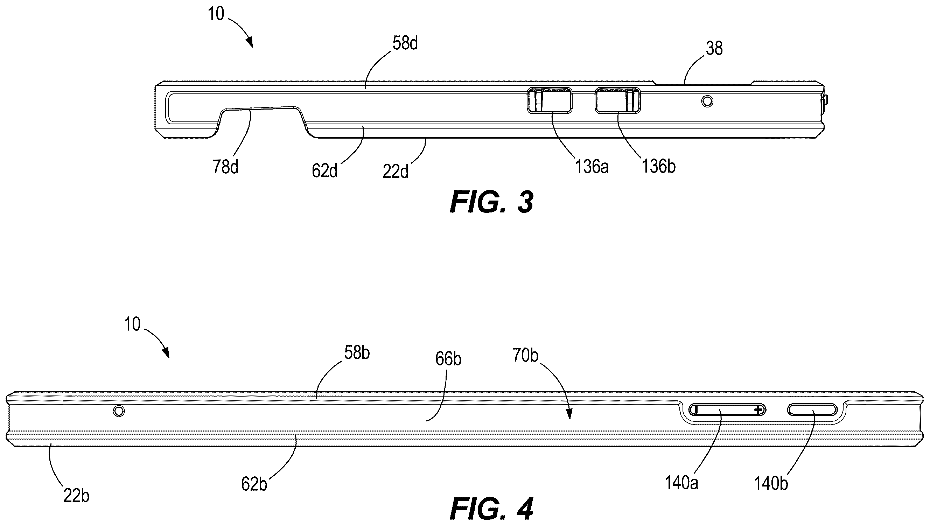

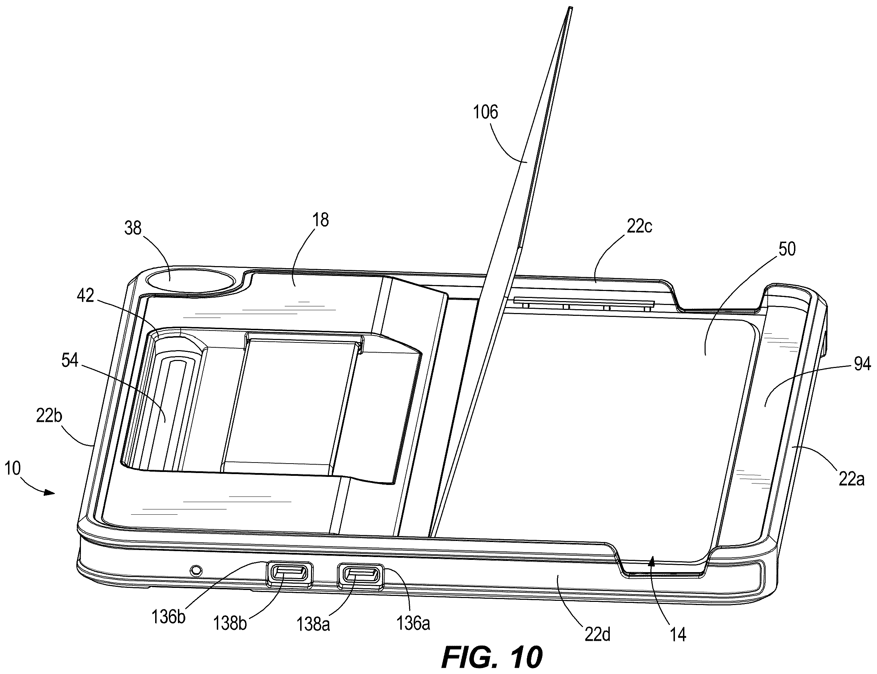

With reference to FIG. 3, two apertures 136a, 136b are defined within the right sidewall 22d. The apertures 136a, 136b are provided for permitting the device 14 to be electrically coupled to peripheral devices, such as power devices (e.g., a portable battery pack, charging cable, etc.) or output devices (e.g., an external monitor, a projection device, etc.). When the device 14 is inserted into the case 10, the apertures 136a, 136b are located along the case 10 to align with a respective electrical port 138a, 138b (FIG. 10) on the device 14.

With reference to FIG. 4, the case 10 further includes a first button 140a and a second button 140b that are formed on the top sidewall 22b. The buttons 140a, 140b are located adjacent the left sidewall 22c. The first button 140a is arranged to align with a power button (not shown) located on the periphery 28 of the device 14. The second button 140b is arranged to align with a volume button (not shown) that is also located on the periphery 28 of the device 14. Each button 140a, 140b is formed as a pliable button such that the buttons 140a, 140b are depressible to contact and operate the power button or the volume button on the device 14. The four sidewalls 22a-d are formed of a plastic material. The buttons 140a, 140b are formed along the top sidewall 22b by an over molding process. As such, the case 10 is formed of materials having thickness, rigidity, and/or impact resistance qualities that provide increased protection for the device 14.

FIGS. 6-13 illustrate a process of installing the case 10 onto the device 14. As shown in FIG. 6, the kickstand 106 of the device 14 is rotated to an extended position for installation. In the extended position, the kickstand 106 extends outward and rearward from the rear surface 50 of the device 14. In FIGS. 7 and 8, the device 14 is angularly oriented relative to the case 10 so that a top portion of the periphery 28 of the device 14 is inserted into and surrounded by the top sidewall 22b. The front surface 30 of the device 14 is obliquely oriented relative to the top sidewall 22b such that a body 144 of the device 14 is externally arranged from the cavity 26. Also, the kickstand 106 of the device 14 extends through the cavity 26 and out of the rear opening 32 of the device 14.

As shown in FIGS. 9-11, the body 144 of the device 14 is received within the cavity 26, and the sidewalls 22a-d are fitted around the periphery 28 of the device 14. The device 14 is rotated so that a remaining portion of the periphery 28 of the device 14 is surrounded by the bottom sidewall 22a, the left sidewall 22c, and the right sidewall 22d. The body 144 of the device 14 is arranged within the case 10 such that the rear surface 50 of the device 14 is seated against the cover 110 and the rear wall 18. The bottom sidewall 22a of the case 10 is specifically shaped to conform with the shape of the device 14. As such, the bottom sidewall 22a is positioned within a recess 148 defined along the rear surface 50 of the device 14. As shown, the device 14 is supported by the sidewalls 22a-d and the rear wall 18.

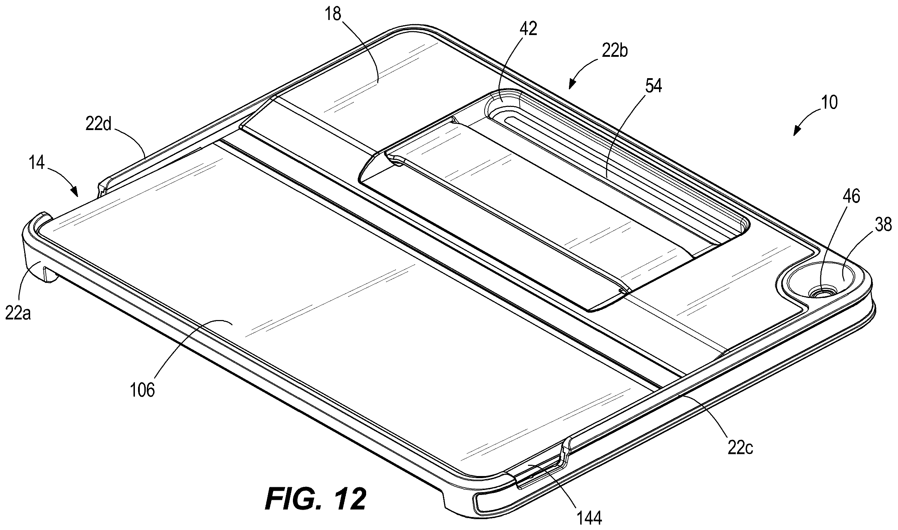

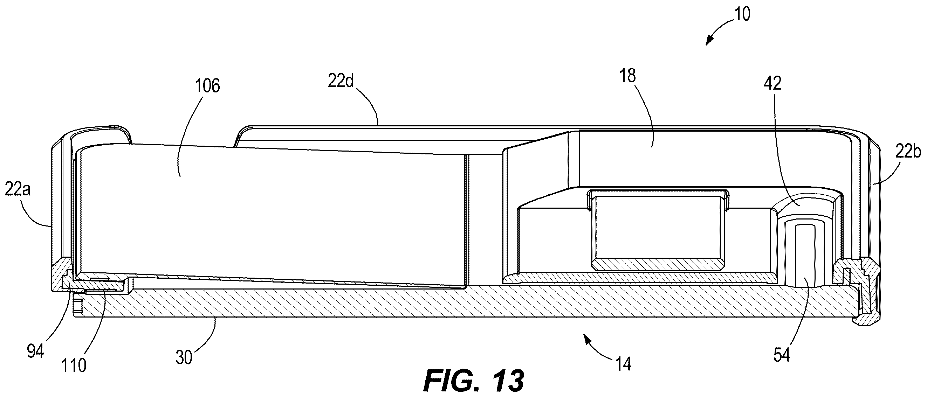

As shown in FIGS. 12 and 13, the kickstand 106 of the device 14 is rotated to a stowed position and secured to the case 10. In the stowed position, the kickstand 106 is positioned against the lip 94 of the bottom sidewall 22a. The lip 94 inhibits the kickstand 106 from contacting the rear surface 50 of the device 14. As such, the magnetic members 102a-e within the lip 94 are configured to interact with the kickstand 106 to keep the kickstand 106 in place and against the case 10. The kickstand 106 may be formed of a metal to interact with the magnetic members 120a-e. In some embodiments, the kickstand 106 may include at least one magnetic member embedded within the kickstand 106. In such embodiments, the magnetic members of the kickstand 106 may interact with the magnetic members 120a-e of the case 10. In other embodiments, the lip 94 may be provided with a metallic member configured to interact with the at least one magnetic member of the kickstand 106.

The case 10 is structured to allow the user to rotate or pivot the kickstand 106 between the extended position and the stowed position when operating the device 14. When the kickstand 106 is rotated to the extended position, the kickstand 106 may be positioned against a horizontal surface (e.g., a table surface). The kickstand 106 is configured to support the case 10 and the device 14 at an angle relative to the horizontal surface. When the kickstand 106 is rotated to the stowed position, the kickstand 106 is magnetically secured to the lip 94 of the bottom sidewall 22a. The stowed position allows the user to hold the device 14 without having to tolerate constant movement of the kickstand 106 during operating or transportation of the device 14. The stowed position also allows the user to place the case 10 and the device 14 against the horizontal surface such that the front surface 30 of the device 14 is oriented parallel to the horizontal surface. As such, the case 10 allows the user to easily operate the device 14 in various positions.

Although the invention has been described in detail with reference to certain preferred embodiments, variations and modifications exist within the scope and spirit of one or more independent aspects of the invention as described.

Various features of the invention are set forth in the following claims.

### PREFERRED FEATURES OF THE INVENTION

1. A case for a portable electronic device having a kickstand, the case comprising:
   a plurality of sidewalls including a first sidewall having a lip configured to securely couple the kickstand to the case;
   a rear wall coupled to at least one sidewall of the plurality of sidewalls; and
   a cavity defined by the plurality of sidewalls and the rear wall, the cavity configured to receive the portable electronic device such that the plurality of sidewalls and the rear wall support the portable electronic device,
   wherein the lip of the first sidewall extends into the cavity.
2. The case of clause 1, wherein the lip of the first sidewall includes a magnetic member configured to interact with the kickstand and magnetically secure the kickstand with the case.
3. The case of clause 2, wherein the lip of the first sidewall includes a recess defined therein and configured to receive the magnetic member.
4. The case of clause 2, wherein the first sidewall has a cover coupled to the lip to lie over the magnetic member.
5. The case of clause 1, wherein the plurality of sidewalls includes a second sidewall, a third sidewall, and a fourth sidewall, and wherein the rear wall is coupled to the second sidewall, the third sidewall, and the fourth sidewall.
6. The case of clause 5, wherein the first sidewall is a bottom sidewall, the second sidewall is a top sidewall, the third sidewall is a left sidewall, and the fourth sidewall is a right sidewall.
7. A case for a portable electronic device having a kickstand, the case comprising:
   a plurality of sidewalls including at least one sidewall having a lip configured to securely couple the kickstand to the case, the lip having a recess defined therein;
   a cavity defined by the plurality of sidewalls, the cavity configured to receive the portable electronic device such that the plurality of sidewalls support the portable electronic device; and
   a magnetic member received within the recess, the magnetic member configured to interact with the kickstand and magnetically secure the kickstand with the case.
8. The case of clause 7, wherein the lip of the at least one sidewall extends into the cavity.
9. The case of clause 7, wherein the recess of the lip has a rectangular shape.
10. The case of clause 7, wherein the recess is a one of a plurality of recesses and the magnetic member is one of a plurality of magnetic members, wherein each of the plurality of magnetic members is positioned in one of the plurality of recesses, and wherein adjacent magnetic members of the plurality of magnetic members are spaced from each other by a gap.
11. The case of clause 7, further comprising a cover coupled to the lip to lie over the magnetic member.
12. A case for a portable electronic device having a kickstand, the case comprising:
   a plurality of sidewalls;
   a lip extending from a first sidewall of the plurality of sidewalls and configured to securely couple the kickstand to the case;
   a set of ribs formed along an interior portion of a second sidewall of the plurality of sidewalls;
   a rear wall coupled to one of the plurality of sidewalls; and
   a cavity defined by the plurality of sidewalls and the rear wall, the cavity configured to receive the portable electronic device such that the plurality of sidewalls and the rear wall support the portable electronic device,
   wherein the lip of the first sidewall extends into the cavity.
13. The case of clause 12, wherein the lip of the first sidewall includes a magnetic member configured to interact with the kickstand and magnetically secure the kickstand with the case.
14. The case of clause 13, wherein the lip of the first sidewall includes a recess defined therein and configured to receive the magnetic member.
15. The case of clause 14, further comprising a cover coupled to the lip to lie over the magnetic member.
16. The case of clause 12, wherein the set of ribs is a first set of ribs and wherein a second set of ribs is formed along an interior portion of at least one sidewall of the plurality of sidewalls in addition to the second sidewall.
17. The case of clause 12, wherein the rear wall is spaced from the first sidewall such that a rear opening is defined therebetween.
18. The case of clause 12, wherein the lip extends from the first sidewall in a direction toward the rear wall.
19. The case of clause 12, further comprising an opening defined within the rear wall and configured to receive an electronic writing implement.
20. The case of clause 12, further comprising an opening defined within the rear wall and configured to surround a camera of the portable electronic device.

## Claims

1. A case for a portable electronic device having a kickstand, the case comprising:
a plurality of sidewalls including a first sidewall having a lip configured to securely couple the kickstand to the case;
a rear wall coupled to at least one sidewall of the plurality of sidewalls; and
a cavity defined by the plurality of sidewalls and the rear wall, the cavity configured to receive the portable electronic device such that the plurality of sidewalls and the rear wall support the portable electronic device,
wherein the lip of the first sidewall extends into the cavity.

2. The case of claim 1, wherein:
the plurality of sidewalls includes a second sidewall, a third sidewall, and a fourth sidewall, and wherein the rear wall is coupled to the second sidewall, the third sidewall, and the fourth sidewall; and optionally
the first sidewall is a bottom sidewall, the second sidewall is a top sidewall, the third sidewall is a left sidewall, and the fourth sidewall is a right sidewall.

3. The case of claim 1, further comprising a set of ribs formed along an interior portion of a second sidewall of the plurality of sidewalls,
and wherein the lip extends from the first sidewall.

4. The case of any preceding claim, wherein the lip of the first sidewall includes a magnetic member configured to interact with the kickstand and magnetically secure the kickstand with the case.

5. The case of any preceding claim, wherein the lip of the first sidewall includes a recess defined therein and configured to receive the magnetic member.

6. The case of any preceding claim, further comprising a cover coupled to the lip to lie over the magnetic member.

7. The case of any preceding claim, wherein the set of ribs is a first set of ribs and wherein a second set of ribs is formed along an interior portion of at least one sidewall of the plurality of sidewalls in addition to the second sidewall.

8. The case of any preceding claim, wherein the rear wall is spaced from the first sidewall such that a rear opening is defined therebetween.

9. The case of any preceding claim, wherein the lip extends from the first sidewall in a direction toward the rear wall.

10. The case of any preceding claim, further comprising an opening defined within the rear wall and configured to:
receive an electronic writing implement; or
surround a camera of the portable electronic device.

11. A case for a portable electronic device having a kickstand, the case comprising:
a plurality of sidewalls including at least one sidewall having a lip configured to securely couple the kickstand to the case, the lip having a recess defined therein;
a cavity defined by the plurality of sidewalls, the cavity configured to receive the portable electronic device such that the plurality of sidewalls support the portable electronic device; and
a magnetic member received within the recess, the magnetic member configured to interact with the kickstand and magnetically secure the kickstand with the case.

12. The case of claim 11, wherein the lip of the at least one sidewall extends into the cavity.

13. The case of claim 11 or 12, wherein the recess of the lip has a rectangular shape.

14. The case of any one of claims 11 to 13, wherein the recess is a one of a plurality of recesses and the magnetic member is one of a plurality of magnetic members, wherein each of the plurality of magnetic members is positioned in one of the plurality of recesses, and wherein adjacent magnetic members of the plurality of magnetic members are spaced from each other by a gap.

15. The case of any one of claims 11 to 14, further comprising a cover coupled to the lip to lie over the magnetic member.
